Europäisches Patentamt

European Patent Office

Office européen des brevets

(19)

(11) Veröffentlichungsnummer: **0 000 571**
**B1**

(12) **EUROPÄISCHE PATENTSCHRIFT**

(21) Anmeldenummer: **78100481.7**

(22) Anmeldetag: **24.07.78**

(51) Int. Cl.³: **G 03 C 7/00, G 03 B 33/00,**
**G 03 F 7/20, G 03 C 5/00,**
**G 02 B 27/42**

(54) Verfahren zum Herstellen eines Originals.

(30) Priorität: **01.08.77 DE 2734580**

(43) Veröffentlichungstag der Anmeldung:
**07.02.79 Patentblatt 79/3**

(45) Bekanntmachung des Hinweises auf die Patenterteilung:
**18.03.81 Patentblatt 81/11**

(84) Benannte Vertragsstaaten:
**BE CH DE FR GB NL**

(56) Entgegenhaltungen:
**DE - A - 2 703 160**
**DE - B - 2 657 246**
**DE - C - 140 907**
**FR - A - 2 151 130**
**FR - A - 2 299 661**
**GB - A - 6 825 AD 1906**
**GB - A - 11 466 AD 1899**
**NL - A - 77 00486**

**APPLIED OPTICS, vol. 15, No. 4, April 1976**
**S. AUSTIN et al: "Fabrication of thin periodic**
**structures in photoresist: a model", Seiten**
**1071—1074**

**Naturwissenschaften, vol. 63, No. 4, April 1976,**
**Springer Verlag**
**M. T. GALE et al: "Farbenphotographie ohne**
**Farbstoffe und Silber", Seiten 180—184**

**OPTICS COMMUNICATIONS, vol. 18, No. 3,**
**August 1976**
**K. KNOP: "Color pictures using the zero**
**diffraction order of phase grating structures",**
**Seiten 298—303**

**OPTICS COMMUNICATIONS, vol. 18, No. 3,**
**August, 1976**
**M. T. GALE "Sinusoidal relief gratings for zero-**
**order reconstruction of black- and -white**
**images", Seiten 292—297**

**SMPTE JOURNAL, vol. 87, No. 1, Januar 1978**
**M. T. GALE et al: "Embossed relief images and**
**their application for color motion pictures",**
**Seiten 6—8**

**C. J. WALL: "The history of three color**
**photography", American Photographic Publishing**
**Co., Boston, 1925, Seiten 670—681**

(73) Patentinhaber: **HOECHST AKTIENGESELLSCHAFT**
**KALLE, Patentabteilung Postfach 3540**
**D-6200 Wiesbaden 1 (DE)**

(72) Erfinder: **Moraw, Roland, Dr.**
**Buchenweg 4**
**D-6201 Naurod (DE)**
(72) Erfinder: **Schädlich, Renate**
**Erbsenacker 13**
**D-6201 Naurod (DE)**

# 0 000 571

## Verfahren zum Herstellen eines Originals

Die Erfindung betrifft ein Verfahren zum Herstellen eines Originals, bei dem eine auf einem Träger befindliche Aufzeichnungsschicht informationsmäßig und gittermäßig zu einem Reliefbild belichtet wird wobei die Aufzeichnungsschicht durch getrennte Farbauszugsvorlagen hindurch belichtet wird, die im Bereich der jeweiligen Projektionsfarbe transparent sind und deren Teilbilder-Bereiche überlappungsfrei aneinander grenzen, und bei dem nach dem Belichten die Aufzeichnungsschicht entwickelt wird.

Ein derartiges Verfahren ist aus der Druckschrift GB—A—6 825 AD 1906 bekannt, nach der das farbige Projektionsbild durch Abbildung des gebeugten Lichtes erzeugt wird, wozu entsprechend den Farbauszügen die Farbauszugsbilder mit Gittern unterschiedlicher Gitterkonstanten moduliert werden. Dabei wird versucht, die verschiedenen Gitterbilder in einer Schicht durch Überlagerung von zwei Gittern sehr unterschiedlicher Gitterkonstanten zu speichern. Hierzu wird bei der Farbauszugsbelichtung den eigentlichen farbbestimmenden Gittern mit unterschiedlichen Gitterkonstanten ein relativ grobes Gitter überlagert, das überdies bei jeder Aufnahme in neue Positionen verschoben wird, wobei der Abstand zwischen den einzelnen Positionen kleiner als die Gitterkonstante des groben Gitters ist. Eine derartige Doppelgitter-Technik mit partieller Verschiebung des Gitters ist sehr schwierig zu handhaben. Es wird weder mit Reliefgittern einheitlicher Gitterkonstanten und mit rechtecksförmigem Gitterprofil gearbeitet, noch wird das ungebeugte Licht für die Projektion verwendet. Eine derartige Abbildungstechnik führt zu keiner exakten farbgetreuen Projektion der Reliefgitterbilder.

Mit der aus der Zeitschrift Laser u. Opto-Elektronik Nr. 3/1976, Seiten 16/17 bekannten ZOD (Zero-Order-Diffraction)-Technik werden gittermäßig gerasterte Bilder erzeugt. Von den Reliefbildern, die beispielsweise drei Grundfarbengittermustern in gelb, magenta und cyan in einem Fotolack entsprechen, werden drei Nickelmatrizen hergestellt, mit denen farblose thermoplastische Folien aus beispielsweise Polyvinylchlorid geprägt werden. Diese Folien werden mechanisch überlagert und bei der Projektion mit konventionellen Projektoren werden von den farblosen Reliefbildern farbige Projektionsbilder erhalten. Die gitterförmige Rasterung erfolgt mit Reliefgittern von rechteckförmigen Querschnitt, wobei die Gitterperiode etwa 1,5 $\mu$m beträgt. Für jeden Farbauszug in magenta, gelb und cyan wird getrennt je eine Nickelmatrize mit unterschiedlicher Relieftiefe erstellt, mit der je eines der getrennten Prägebilder erzeugt wird. Die Relieftiefen sind unterschiedlich, wobei die Relieftiefe beim Cyanauszug am größten und beim Gelbauszug am kleinsten ist. Diese Prägebilder sind gerastert. Die Prägebilder werden zu einem dreischichtigen Reliefbild überlagert, von dem farbige Bilder projiziert werden können. Die beschriebene Technik ergibt sehr helle Farbbilder großer Auflösung. Die Reliefbilder können durch Prägen relativ billig und schnell vervielfältigt werden.

Ein Nachteil, der die Einführung dieser Technik erschwert, ist der aufwendige Herstellungsprozeß mit drei vollständig getrennten Arbeitsgängen zur Herstellung der einzelnen, den Farbauszügen entsprechenden geprägten Reliefbilder. Ein weiterer Nachteil ist das paßgerechte Zusammensetzen der drei getrennten Reliefbilder zu dem für die farbige Projektion erforderlichen Duplikatbild. In der nicht zum Stand der Technik gehörenden deutschen Patentschrift 26 57 246 ist bereits ein Lösung angegeben, die diese nachteile vermeidet. Danach setzt sich das Reliefbild aus den den einzelnen Farbauszügen entsprechenden Relief-Teilbildern in der Weise zusammen, daß verschiedenfarbige Bereiche, das können bei gerasterten Bildern auch Rasterpunkte sein, in einer Ebene angeordnet sind, wobei sich die verschiedenfarbigen Bereiche jedoch nicht überschneiden, sondern höchstens berühren. Derartige Reliefbilder eignen sich sehr gut zur Darstellung von flächenhaften mehrfarbigen Vorlagen, wie graphischen Darstellungen, in Form von Reliefgitterstrukturen in einer Ebene.

Bei dem in der deutschen Patentschrift 26 57 246 offenbarten Verfahren werden die gittermäßige Belichtung und die bildmäßigen farbauszugsweisen Belichtungen zeitlich getrennt durchgeführt, wobei die gittermäßige Belichtung durch die Fotolackschicht hindurch bis zum Trägermaterial erfolgt. Dieses Verfahren arbeitet mit drei Grundfarben.

Eine Weiterentwicklung der Gitterbildaufzeichnung verwendet vier Grundfarben, für die entsprechende Farbauszugsvorlagen für die Farbauszugsbelichtungen durch einfache Kontaktbelichtung eingesetzt werden.

Aufgabe der Erfindung ist es, das eingangs beschriebene Verfahren so zu verbessern, daß es bei zumindest gleichbleibender Qualität der Projektionsbilder in bezug auf Helligkeit und Bildschärfe zu einer Zeitersparnis bei den Belichtungen der Aufzeichnungsschicht kommt.

Diese Aufgabe wird erfindungsgemäß dadurch gelöst, daß zuerst gittermäßig und danach informationsmäßig belichtet wird, daß die gittermäßige Belichtung über den gesamten Bildbereich und bis zu einer einheitlichen Relieftiefe, die kleiner als die Dicke der Aufzeichnungsschicht ist, erfolgt, daß die informationsmäßige Belichtung durch jede Farbauszugsvorlage mit unterschiedlicher Energiedichte vorgenommen wird und daß die bei jeder bildmäßigen Belichtung verwendete Energiedichte kleiner ist als die bei der Belichtung einer gleichartigen Aufzeichnungsschicht durch dieselbe Farbauszugsvorlage ohne vorherige gittermäßige Belichtung zur Erzielung der gewünschten Auszugsfarbe erforderliche Energiedichte.

Es wird dabei so vorgegangen, daß bis zu einer einheitlichen Relieftiefe, die einer bestimmten Projektionsfarbe entspricht, gittermäßig belichtet wird. Die Anpassung der Gittertiefe für das jeweilige Farbauszugsbild erfolgt somit bei der gitterfreien bildmäßigen Belichtung. Die Erklärung hierfür scheint zu sein, daß zunächst in einer Gitteraufbauphase die Relieftiefe zunimmt, da die anbelichteten Schichtteile schneller ausbelichten als die bis dahin durch Stege des Strukturgitters abgedeckten Schichtteile, und dann eine Gitterabbauphase folgt, in der die Relieftiefe wieder abnimmt, besonders bei der Annäherung an den Träger in der Endphase der Belichtung. Abgesehen von der Endphase ist der Gitteraufbau und Gitterabbau weitgehend unabhängig von der Schichtdicke des Aufzeichnungsmaterials, beispielsweise eines Fotolackes. Die Reproduzierbarkeit und die Leuchtkraft der Projektionsfarben sind jedenfalls gleich oder sogar besser als bei sofortiger gittermäßiger Belichtung des Aufzeichnungsmaterials bis zum Erreichen des Trägers.

In Ausgestaltung der Erfindung wird bis zu einer einheitlichen Relieftiefe, die der Projektionsfarbe grün oder gelb entspricht, gittermäßig belichtet. Die Anzahl der bildmäßigen farbauszugsweisen Belichtungen kann dadurch um eins reduziert werden, wodurch sich eine Zeitersparnis ergibt.

Es ist offensichtlich, daß für die reproduzierbare Erzeugung vorgegebener Relieftiefen und damit bestimmter Projektionsfarben alle Aufzeichnungsparameter mit großer Genauigkeit konstant gehalten werden müssen. Um Schwankungen in den Projektionsfarben durch schwer erfaßbare Einflüsse zu berücksichtigen, wird eine Eichkurve aufgenommen, der dann für einige Zeit die effektiven Belichtungszeiten des Aufzeichnungsmaterials entnommen werden können.

Zur Herstellung eines Originals werden etwa 2,5 $\mu$m dicke Schichten eines Fotolacks auf einem Träger bildmäßig und gittermäßig belichtet. Die bildmäßige Belichtung erfolgt vorzugsweise im Kontakt mit der jeweiligen Farbauszugsvorlage bzw. einer Schwarzauszugsvorlage, die gittermäßige Belichtung im Kontakt mit einer Gittervorlage, beispielsweise einer Glasplatte mit lichtdurchlässigen Stellen und durch Metallstege lichtundurchlässig abgedeckten Stellen. Bei den bevorzugten positiven Fotolacken mit o-Chinondiaziden, bei denen die belichteten Schichtteile bei der Entwicklung weggelöst werden, wird aktinisches Licht eingestrahlt, beispielsweise paralleles Licht einer 200 Watt-Quecksilberhochdrucklampe durch eine Quarzlinse mit der Brennweite f = 15 cm und durch ein Blauglasfilter mit maximaler Transmission von 75% der Lichtintensität bei 400 nm Wellenlänge. Zur Herstellung einer Metallmatrize zum Prägen des Informationsträgers wird das Original mit einer dünnen elektrisch leitenden Schicht beschichtet, auf der galvanisch ein Metallüberzug abgeschieden wird. Anschließend werden das Original und der Metallüberzug, dessen Kontaktfläche mit dem Original das Negativ-Reliefbild des Originals darstellt, voneinander getrennt. Ein verformbares Material, aus dem der Informationsträger erzeugt wird, beispielsweise Polyvinylchlorid, wird mit der so hergestellten Metallmatrize in an sich bekannter Weise unter Druck und unter meist temperaturbedingter Viskositätserniedrigung geprägt.

Anhand der nachstehenden Beispiele sind die auftretenden Projecktionsfarben bei bestimmten eingestrahlten Energie dichten ersichtlich.

## Beispiel 1

Zunächst wird eine Eichkurve für eine etwa 2,5 $\mu$m dicke Schicht aus einem positiv arbeitenden Fotolack, wei ihn beispielsweise die Shipley Comp. Inc., Newton, Mass., U.S.A., herstellt, aufgenommen. Hierzu wird der Fotolack durch Schleudern und Trocknen auf einer blanken transparenten Polyesterfolie aufgebracht. Anschließend wird diese Schicht in Kontaktanordnung mit einem Gitter von 600 Linien/mm aus Metallstegen auf einer Glasplatte mit aktinischem Licht bestrahlt, wäßrig alkalisch entwickelt und mit weißem Licht durchstrahlt. Dabei treten in Abhängigkeit von der zugeführten Energiedichtedie in Spalte 2 von Tabelle 1 zusammengestellten Projektionsfarben der Eichkurve auf.

**0 000 571**

TABELLE 1

| Gitterbelichtung | | homogene Nachbelichtung [1] | |
| Energiedichte (mJ /cm²) | Projectionsfarben | Energiedichte (mJ /cm²) | Projektionsfarben |
|---|---|---|---|
| 75 | gelbbraun | 0 | grün (sehr hell) |
| 85 | rotbraun | 15 | gelbgrün (sehr hell) |
| 95 | blau-violett (sehr hell) | 45 | blaugrün (hell) |
| 135 | gelb (sehr hell) | 70 | magentarot (sehr hell) |
| 155 | magentarot (sehr hell) | 90 | gelb (sehr hell) |
| 185 | blaugrün (sehr hell) | 120 | blau-violett (hell) |
| 240 | grün (sehr hell) | | |
| 360 | magenta | | |

[1] erfolgt nach gittermäßiger Belichtung der Aufzeichnungsschicht mit einer Energiedichte von 240 mJ /cm²

Soll nun beispielsweise bei der späteren bildmäßigen Belichtung die Projektionsfarbe grün erhalten werden, ohne hierzu eine homogene Nachbelichtung mittels einer Farbauszugsvorlage für grün vornehmen zu müssen, so wird eine neue gleichartige Aufzeichnungsschicht mit 240 mJ/cm² gittermäßig belichtet und anschließend bildmäßig nachbelichtet. Dabei treten in Abhängigkeit von der zugeführten Energiedichte für die Nachbelichtung die in Tabelle 1 in Spalte 4 angeführten Projektionsfarben auf.

Wie ein Vergleich zeigt, weicht die Projektionsfarbe magenta, das ist ein Rot mit einer Tönung ins Blaue, die einer eingestrahlten Energiedichte von 360 mJ/cm² bei der Gitterbelichtung entspricht, von der Projektionsfarbe blau-violett, die einer eingestrahlten Energiedichte von 120 mJ/cm² bei der homogenen Nachbelichtung entspricht, ab, obwohl durch die Nachbelichtung auf die Aufzeichnungsschicht eine Energiedichte von 240 mJ/cm² + 120 mJ/cm² = 360 mJ/cm² insgesamt appliziert wurde, d.h. die gleiche Menge wie bei der Gitterbelichtung allein. Dieser Farbunterschied ist darauf zurückzuführen, daß bei der Gitterbelichtung die unterhalb der Gitterstege liegenden Schichtteile des Fotolacks nicht direkt ausbelichtet werden, sondern durch Streulicht nur geringfügig abgebaut werden, während bei der homogenen Nachbelichtung das Gitter entfernt ist und die nicht mehr abgedeckten Schichtteile durch Belichtung abgebaut werden.

Die Bildherstellung erfolgt in der Weise, daß eine neue Schicht aus Fotolack mit 240 mJ/cm² gittermäßig belichtet wird. Anschließend wird unter paßgerecht aufgelegten Farbauszugsvorlagen belichtet, die nur an den Bildstellen der jeweiligen Farbauszugsfarbe und an den weißen Bildstellen transparent sind, und zwar werden zum Erzielen der Projektionsfarben rot/gelb/blau die Farbauszugsvorlagen mit Energiedichten von 70/90/120 mJ/m² durchstrahlt. Einer Schwarzauszugsvorlage wird gekreuzt zum Gitter bei der Vorbelichtung ein Gitter von 138 Linien/mm aufgelegt und es wird eine Energiedichte von 140 mJ/cm² eingestrahlt.

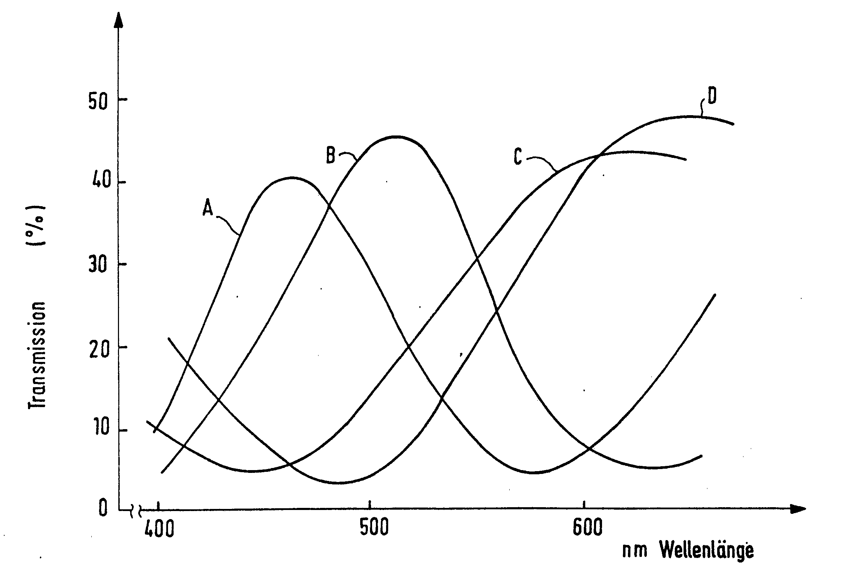

Nach der wäßrigalkalischen Entwicklung wird das erhaltene Original mit weißem Licht durchstrahlt und mittels einer Optik der Lichtstärke 1:2,8 ein buntes Bild entsprechend der Vorlage projiziert. Die schwarzen Bildstellen sind eher als dunkelbraun denn als schwarz zu bezeichnen. An den farbigen Bildstellen wurden die spektralen Transmissionen gemessen, die in der Figur dargestellt sind. Über einem Streulichtanteil von etwa 3% bauen sich Transmissionen mit Maximalwerten um 50% auf, wobei die Kurve A für blau-violett ein Maximum bei ungefähr 460 nm, die Kurve B für grün ein Maximum bei etwa 510 nm, die Kurve C für gelb ein Maximum von ca. 620 nm und die Kurve D für rot, mit einer Orientierung nach magenta, ein Maximum bei ungefähr 650 nm besitzen.

Bei Weiterverarbeitung des Originals zu einer Prägematrize durch Herstellung einer Metallform, mit der PVC-Folien geprägt werden können, müssen für entsprechende Farbwiedergabe von den geprägten PVC-Folien die Belichtungszeiten mit einem Faktor 1,06 multipliziert werden, um die

4

# 0 000 571

unterschiedlichen Brechungsindizes zwischen PVC-Folie und der Fotolackschicht zu berücksichtigen.

## Beispiel 2

Eine etwa 3,5 $\mu$m dicke Schicht aus dem gleichen Fotolack wie im Beispiel 1 wird in Kontaktanordnung mit einem Gitter von 138 Linien/mm aus Metallstegen auf einer Glasplatte mit aktinischem Licht bestrahlt, wäßriglakalisch entwickelt und mit weißem Licht durchstrahlt. Das Projektionslicht wird durch eine langbrennweitige, abgeblendete Optik geführt. Dabei treten in Abhängigkeit von der Größe der zugeführten Energiedichten die in Tabelle 2, Spalte 2 zusammengestellten Projektionsfarben auf.

### TABELLE 2

| Gitterbelichtung | | homogene Nachbelichtung [1] | |
|---|---|---|---|
| Energiedichten (mJ /cm$^2$) | Projektionsfarben | Energiedichten (mJ /cm$^2$) | Projektionsfarben |
| 70 | gelbbraun | 0 | gelb |
| 80 | rotbraun | 30 | magentarot |
| 90 | blau-violett | 50 | blau |
| 120 | gelb | 80 | grün |
| 140 | magentarot | – | – |
| 165 | blaugrün | – | – |
| 195 | grün | – | – |
| 260 | magenta | – | – |

(1) erfolgt nach gittermäßiger Belichtung der Aufzeichnungsschicht mit einer Energiedichte von 120 mJ /cm$^2$

Sol bei der späteren bildmäßigen Belichtung die Projektionsfarbe gelb ohne Nachbelichtung erhalten werden, so wird eine gleichartige Aufzeichnungsschicht mit einer Energiedichte von 120 mJ/cm$^2$ gittermäßig belichtet und anschließend bildmäßig nachbelichtet. Dabei treten in Abhängigkeit von den zugeführten Energiedichten die in Tabelle 2, Spalte 4 angegebenen Projektionsfarben auf.

Die bildmäßige Belichtung erfolgt analog zu dem anhand des Beispiels 1 beschriebenen Verfahren.

## Beispiel 3

Eine etwa 2,5 $\mu$m dicke Schicht aus einem sensitometrisch härteren Fotolack als in den Beispielen 1 und 2 wird in Kontaktanordnung mit einem Gitter von 600 Linien/mm aus Metallstegen auf einer Glasplatte mit aktinischem Licht bestrahlt, wäßrigalkalisch entwickelt und mit weißem Licht durchstrahlt. Das Projektionslicht wird durch eine Optik der Lichtstärke 1:2,8 abgebildet. Dabei treten in Abhängigkeit von den zugeführten Energiedichten die in Tabelle 3, Spalte 2 folgenden Projektionsfarben auf.

5

**0 000 571**

TABELLE 3

| Gitterbelichtung | | homogene Nachbelichtung [1] | |
|---|---|---|---|
| Energiedichte (mJ/cm²) | Projektionsfarben | Energiedichte (mJ/cm²) | Projektionsfarben |
| | | 25 | grünblau |
| 90 | blau-violett | 45 | magentarot |
| 95 | gelb | 55 | gelb |
| 105 | magentarot | 85 | blau-violett |
| 120 | blau | — | — |
| 160 | magentarot | — | — |
| 180 | gelb | — | — |
| 225 | blau-violett | — | — |

(1) erfolgt nach gittermäßiger Belichtung mit 90 mJ/cm²

An der im Vergleich zum im Beispiel 1 verwendeten Fotolack kleinen Abstufung der Energiedichten untereinander ist ersichtlich, daß der eingesetzte Fotolack sensitometrisch hart arbeitet. Zur Farbabstufung durch homogene Nachbelichtung wird zuerst mit 90 mJ/cm² durch ein Gitter von 600 Linien/mm bestrahlt, um die Projektionsfarbe blau-violett zu erhalten. Anschließend wird homogen nachbelichtet. Dabei treten in Abhängigkeit von den zugeführten Energiedichten die in Tabelle 3, Spalte 4 zusammengestellten Projektionsfarben auf.

**Patentansprüche**

1. Verfahren zum Herstellen eines Originals, bei dem eine auf einem Träger befindliche Aufzeichnungsschicht informationsmäßig und gittermäßig zu einem Reliefbild belichtet wird, wobei die Aufzeichnungsschicht durch getrennte Farbauszugsvorlagen hindurch belichtet wird, die im Bereich der jeweiligen Projektionsfarbe transparent sind und deren Teilbilder-Bereiche überlappungsfrei aneinander grenzen, und bei dem nach dem Belichten die Aufzeichnungsschicht entwickelt wird, dadurch gekennzeichnet, daß zuerst gittermäßig und danach informationsmäßig belichtet wird, daß die gittermäßige Belichtung über den gesamten Bildbereich und bis zu einer einheitlichen Relieftiefe, die kleiner als die Dicke der Aufzeichnungsschicht ist, erfolgt, daß die informationsmäßige Belichtung durch jede Farbauszugsvorlage mit unterschiedlicher Energiedichte vorgenommen wird und daß die bei jeder bildmäßigen Belichtung verwendete Energiedichte kleiner ist als die bei der Belichtung einer gleichartigen Aufzeichnungsschicht durch dieselbe Farbauszugsvorlage ohne vorherige gittermäßige Belichtung zur Erzielung der gewünschten Auszugsfarbe erforderliche Energiedichte.

2. Verfahren nach Anspruch 1, dadurch gekennzeichnet, daß bis zu einer einheitlichen Relieftiefe, die der Projektionsfarbe grün entspricht, gittermäßig belichtet wird.

3. Verfahren nach Anspruch 1, dadurch gekennzeichnet, daß bis zu einer einheitlichen Relieftiefe, die der Projektionsfarbe gelb entspricht, gittermäßig belichtet wird.

4. Verfahren nach den Ansprüchen 1 bis 3, dadurch gekennzeichnet, daß nach der gittermäßigen Belichtung mit abgestuften Energiedichten (n—1)-mal teilbildmäßig gitterfrei durch Farbauszugsvorlagen belichtet wird, wenn n die Anzahl der im Farbsystem verwendeten Projektionsfarben ist.

5. Verfahren nach den Ansprüchen 1 bis 4, dadurch gekennzeichnet, daß durch eine Vorlag für einen Schwarzauszug hindurch belichtet wird.

6. Verfahren nach den Ansprüchen 1 bis 5, dadurch gekennzeichnet, daß die Farbauszugsvorlagen nur an den Bildstellen der jeweiligen Farbauszugsfarbe und an den weißen Bildstellen transparent sind.

6

## 0 000 571

### Revendications

1. Procédé pour l'obtention d'un original, dans lequel on expose une couche d'enregistrement se trouvant sur un support, selon une image et sous une grille pour obtenir une image en relief, la couche d'enregistrement recevant la lumière à travers des modèles de sélection colorée séparés qui sont transparents dans le domaine de chaque couleur de projection et dont les zones des images partielles s'avoisinent sans superposition et dans lequel on développe la couche d'enregistrement après l'exposition, caractérisé en ce qu'on expose d'abord sous une grille et ensuite selon une information, l'exposition sous une grille étant effectuée sur toute l'étendue de l'image et jusqu'à une profondeur de relief uniforme inférieure à l'épaisseur de la couche d'enregistrement, on effectue l'exposition selon une image à travers chacun des modèles de sélection colorée avec une densité énergétique différente et en ce que la densité énergétique employée pour chaque exposition selon une image est inférieure à la densité énergétique nécessaire pour l'obtention de la couleur de sélection souhaitée, lors de l'exposition d'une couche d'enregistrement similaire à travers le même modèle de sélection colorée sans exposition préalable sous une grille.

2. Procédé selon la revendication 1, caractérisé en ce qu'on expose sous une grille jusqu'à une profondeur de relief uniforme correspondant à la couleur de projection vert.

3. Procédé selon la revendication 1, caractérisé en ce qu'on expose sous une grille jusqu'à une profondeur de relief uniforme correspondant à la couleur de projection jaune.

4. Procédé selon l'une quelconque des revendications 1 à 3, caractérisé en ce qu'après l'exposition sous une grille avec des densités énergétiques échelonnées, on expose (n—1) fois selon une image partielle sans grille à travers des modèles de sélection colorée, $n$ étant le nombre de couleurs de projection utilisées sans le système coloré.

5. Procédé selon l'une quelconque des revendications 1 à 4, caractérisé en ce qu'on expose à travers un modèle pour une sélection noire.

6. Procédé selon l'une quelconque des revendications 1 à 5, caractérisé en ce que les modèles de sélection colorée ne sont transparents que dans les zones d'image de chaque couleur de sélection et dans les zones d'image blanches.

### Claims

1. A process for the preparation of an original, wherein the recording layer which has been applied to a carrier material is information-wise and grid-wise exposed and developed to give a relief image, the recording layer being exposed through individual color separation originals which are transparent in the areas of the appropriate projection colors and whose part-image areas adjoin one another without overlapping, and wherein the recording layer is developed after the exposure, characterized in that after the grid-wise exposure the information-wise exposure is carried out, in that the grid-wise exposure is carried out over the entire image area and up to a uniform relief depth which is smaller than the thickness of the recording layer, in that the information-wise exposure is carried out with a different energy density for each color separation original, and in that said energy density used for each image-wise exposure through an individual color separation original is lower than the energy density required for an exposure of a similar recording layer through the same color separation original without a preceding grid-wise exposure, to obtain the required projection color.

2. A process according to claim 1, characterized in that the grid-wise exposure is carried out up to a uniform relief depth which corresponds to the projection color green.

3. A process according to claim 1, characterized in that the grid-wise exposure is carried out up to a uniform relief depth which corresponds to the projection color yellow.

4. A process according to claims 1 through 3, characterized in that after the grid-wise exposure (n—1) part-imagewise exposures are carried out through color separation originals without a grid and at graded energy densities, n being the number of projection colors used in the color system.

5. A process according to claims 1 through 4, characterized in that the exposure is carried out through an original for a black separation.

6. A process according to claims 1 through 5, characterized in that the color separation originals are transparent in the image areas of the particular color separation colors and in the white image areas only.

0 000 571